# EUROPEAN PATENT APPLICATION

(11) **EP 1 650 322 A1**
(43) Date of publication of application: **26.04.2006**
(21) Application number: 05021891.6
(22) Date of filing: 07.10.2005
(51) Int. Cl.: C23C 14/34, C22C 21/00, C22C 21/02

(54) **Backing plates for sputtering targets**

(30) Priority: 19.10.2004 JP 2004304701
(71) Applicant: Kobelco Research Institute, Inc., Kobe-shi, Hyogo 651-0073 (JP)
(72) Inventor: Moyama, Kazuki c/o Takasago Works Kobe Steel Ltd., Takasago-shi, Hyogo 676-8670 (JP); Morimoto, Hidekazu c/o Takasago Works Kobe Steel, Takasago-shi, Hyogo 676-8670 (JP)
(74) Representative: Müller-Boré & Partner Patentanwälte

(57) **Abstract**

A backing plate for sputtering targets contains an aluminum alloy having an average coefficient of linear expansion of 23. 0×10⁻⁶/°C or less at temperatures of 25°C to 100°C. This backing plate prevents warp occurring upon bonding with a target, reduces stress occurring upon film deposition (sputtering) of Al-Nd alloy thin films, saves the flattening process of the warp, is reduced in cracking of a brazing filler metal arranged between the target and the backing plate and thereby enables stable film deposition operation over a long period of time.

## Description

The present invention relates to backing plates for sputtering targets. Specifically, it relates to backing plates for sputtering targets which prevent warp occurring upon bonding with a target and/or film deposition (sputtering) of Al-Nd alloy thin films and enable stable film deposition operation over a long period of time.

A sputtering process is generally employed for the fabrication of thin films constituting liquid crystal panels and organic electroluminescence (EL) panels for use in television sets, laptop computers, and other monitors, and interconnection films for use in the fields of optical recording and semiconductors. In the sputtering process, plasma discharge is induced between a substrate and a target serving as a material for films, a gas ionized by the plasma discharge is collided to the target to thereby beat atoms out of the target, and the atoms are deposited on the substrate to thereby fabricate a thin film. This process is advantageous in that a thin film having the same composition as the target can be deposited, in contrast to vacuum vapor deposition and arc ion plating (AIP) .

A flat target having, for example, a rectangular or orbicular shape is generally used in the sputtering process. The target is generally brazed to a backing plate (also referred to as cooling plate or support) for cooling and/or support the target.

In general, copper or copper alloy backing plates featured by high thermal conductivities are used as the backing plate for the purpose of cooling the target heated upon film deposition. The target often comprises a metal material corresponding to the thin film to be deposited, such as aluminum, aluminum alloys, Mo, Ta or Ti, being different from that of the backing plate.

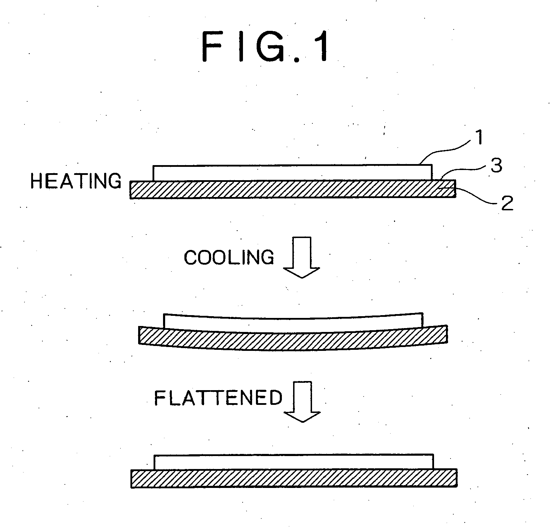

The resulting assembly prepared by brazing these members comprising different metal materials, however, often warps and must be flattened as illustrated in FIG. 1. When the flattened assembly is subjected to film deposition, it will again warp due to repetitive heating and cooling. Thus, procedures of film deposition, in which the assembly warps, and flattening of the warped assembly must be repeated again and again, which results in complicated operations. In addition, a brazing filler metal 3 arranged between the target 1 and the backing plate 2 undergoes cracking to thereby cause delamination of the target 1 and the backing plate 2 before the consumption of the target 1. Thus, repetitive film deposition cannot be achieved.

As a possible solution to the problem in brazing between a target and a backing plate (support), Japanese Patent Application Laid-Open (JP-A) No. 2003-183822 discloses a sputtering target including a target and a backing plate bonded with the interposition of a bonding member, in which the backing plate has a concave portion for housing the bonding member, and the concave portion has a communicating recess in its outer peripheral wall, which recess communicates to the concave portion. The document mentions that this structure prevents warp of the target even when the bonding member solidifies and shrinks. This technique, however, does not aim at the prevention of delamination of the bonding portion (brazing filler metal) and must use a backing plate having a complicated shape.

Japanese PatentApplicationLaid-Open (JP-A) No. 08-246144 proposes a technique for preventing warp and cracking of a sputtering target and delamination of a brazing portion by arranging a plate member having a higher coefficient of thermal expansion and another plate member having a lower coefficient of thermal expansion than the sputtering target so as to integrally sandwich a backing plate. This prevents warp of the backing plate and imparts thermal expansion properties equivalent to those of the target to be supported to the sputtering target. This technique, however, is also disadvantageous in complicated structure of the backing plate.

Japanese PatentApplicationLaid-Open (JP-A) No. 10-046327 proposes a technique of fabricating a target and a backing plate from aluminum alloys, for the purpose of reducing the difference in coefficient of linear expansion between the two members. The combination of the target with the backing plate according to the technique does not sufficiently and reliably reduce the difference in coefficient of thermal expansion and does not prevent cracking of the brazing filler metal. In addition, if the backing plate is fabricated from the same material typically as an Al-Nd alloy target, the cost increases.

Under these circumstances, an object of the present invention is to provide a backing plate for sputtering targets which can reduce or prevent warp occurring upon bonding with a target and stress occurring upon film deposition (sputtering) of Al-Nd alloy thin films and thereby enables stable film deposition operation over a long period of time.

Specifically, the present invention provides backing plate for sputtering targets, containing an aluminum alloy, wherein the aluminum alloy has an average coefficient of linear expansion of 23.0x10⁻⁶/°C or less at temperatures of 25°C to 100°C.

The average coefficient of linear expansion is determined by using a testing instrument Thermoflex TMA 8140 available from Rigaku Corporation according to "Test Method of Coefficient of Linear Expansion of Plastics by Thermomechanical Analysis" specified in Japanese Industrial Standards (JIS) K 7197.

An aluminum alloy containing 2.5% by mass or more of Si or an aluminum alloy containing 5.5% by mass or more of Mn is preferably used as the aluminum alloy having an average coefficient of linear expansion of 23.0x10⁻⁶/°C or less at temperatures of 25°C to 100°C.

For ensuring properties as backing plates for sputtering targets, such as strength, corrosion resistance and workability, the aluminum alloy preferably contains at least one selected from the group consisting of aluminum alloys of JISA 1000 series, A 5000 series and A 6000 series and further contains 2.5% by mass or more of Si or 5.5% by mass or more of Mn.

The backing plate for sputtering targets having a relatively low average coefficient of linear expansion at temperatures of 25°C to 100°C is advantageously used as backing plates for aluminum alloy sputtering targets and further advantageously used as backing plates for aluminum alloy sputtering targets containing 0.1 to 3 atomic % of Nd. This significantly reduces cracking and delamination of a brazing filler metal than conventional backing plates.

The backing plates for sputtering targets according to the present invention is reduced in warp occurring upon bonding with a target and stress occurring upon film deposition (sputtering) of Al-Nd alloy thin films, thereby saves the flattening process of the warp, is reduced in cracking of a brazing filler metal arranged between the target and the backing plate and thereby enables stable film deposition operation over a long period of time. The cracking of the brazing filler metal is caused by repetitive warp and flattening.

Further objects, features and advantages of the present invention will become apparent from the following description of the preferred embodiments with reference to the attached drawings.
FIG. 1 is a side view schematically illustrating cracking in a brazed portion;
FIG. 2 is a graph showing the relation between the Si content and the coefficient of linear expansion of an aluminum alloy of JIS A 1100;
FIG. 3 is a graph showing the relation between the Mn content and the coefficient of linear expansion of an aluminum alloy of JIS A 1100; and
FIG. 4 is a top view showing measurement points on warp of an assembly in the bonding test in the examples.

The present inventors made intensive investigations on backing plates for sputtering targets which are reduced in warp occurring upon bonding with a target and stress occurring upon film deposition (sputtering) of Al-Nd alloy thin films, save the flattening of the warp, are reduced in cracking of a brazing filler metal arranged between the target and the backing plate caused by repetitive warp formation and flattening, and thereby enable stable film deposition operation over a long period of time. Particularly, they made intensive investigations on backing plates for sputtering targets which are reduced in the warp, thereby save the flattening and enable repetitive film deposition even when the targets comprise Al alloys such as A1-Nd, Al-Ti, and Al-Ta alloys or metals such as Mo, Ta, and Ti featured by relatively low coefficients of linear expansion.

Consequently, they have found that an optimum backing plate for the sputtering targets comprises an aluminum alloy having an average coefficient of linear expansion of 23.0x10⁻⁶/°C or less at temperatures of 25°C to 100°C.

The aluminum alloy is not limited in species, as long as it has an average coefficient of linear expansion of 23.0×10⁻⁶/°C or less at temperatures of 25°C to 100°C. Examples thereof are aluminum alloys comprising any of pure metallic aluminum or existing aluminum alloys and further comprising one or more alloying elements such as Si, Mn, Mg, Nd, Ti and Ta. The aluminum alloy for use herein specifically preferably comprises Si or Mn for achieving an aluminum alloy having sufficient corrosion resistance and strength at low cost.

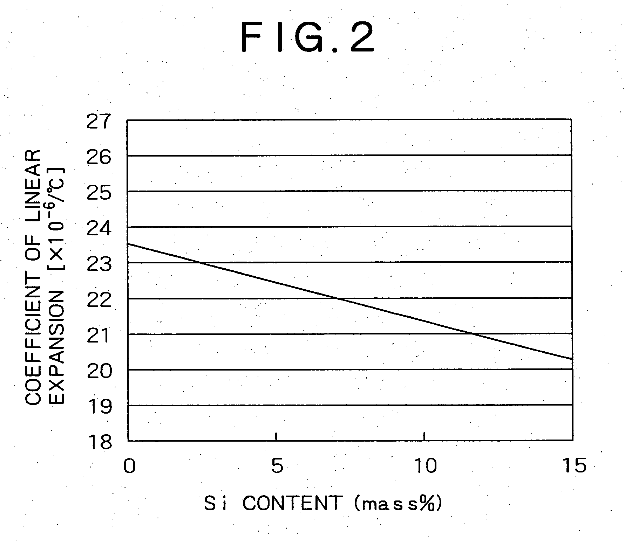

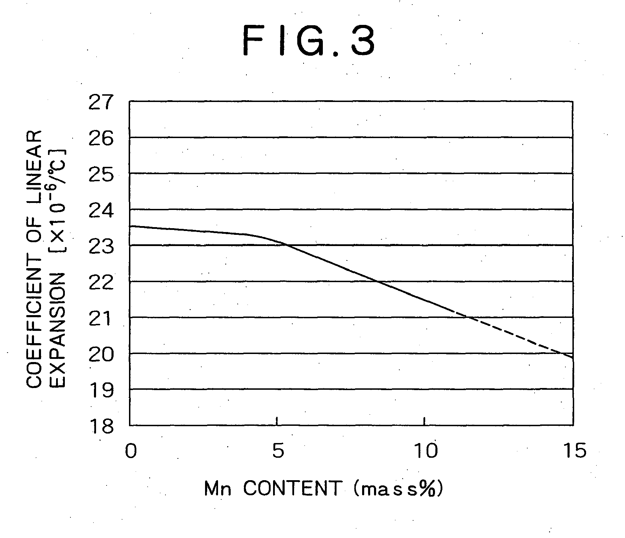

FIG. 2 and FIG. 3 are graphs showing the change in average coefficient of linear expansion at temperatures of 25°C to 100°C with a varying content of Si or Mn added to an existing aluminum alloy of JIS A 1100. FIG. 2 and FIG. 3 demonstrate that the coefficient of linear expansion decreases proportionally to an increasing content of Si or Mn, and that Si should be added so that the aluminum alloy has a Si content of 2.5% by mass or more or the aluminum alloy has a Mn content of 5.5% by mass or more for achieving an average coefficient of linear expansion of 23.0x10⁻⁶/°C or less, as specified in the present invention.

Since the coefficient of linear expansion decreases with an increasing Si or Mn content as illustrated in FIG. 2 and FIG. 3, it is enough to set the upper limit of the Si or Mn content in the aluminum alloy according to the coefficient of linear expansion of the target and to set the upper limit thereof so that the difference in coefficient of linear expansionbetween the backing plate and the target to be brazed is not excessively large.

When an Al-Nd alloy, for example, is used as the target, the backing plate is preferably an aluminum alloy of JIS A 1100 incorporated with 2.5 to 10% by mass of Si, as demonstrated in FIG. 2.

The addition of Si or Mn in an excessive amount may cause decreased workability of the backing plate. For ensuring good workability, the Si or Mn content is preferably 10% by mass or less . When the backing plate further comprises Mn in addition to Si, the corrosion resistance may further be improved. This is probably because Si forms a compound with Mn.

The aluminum alloy can be pure aluminum or an existing aluminum alloy according to JIS specifications, being incorporated with Si to have a Si content of 2.5% by mass or more, or with Mn to have a Mn content of 5.5% by mass or more.

The aluminum alloy for use in the present invention is specifically preferably an aluminum alloyselected from aluminum alloys of JIS A 1000. series, A 5000 series and A 6000 series and further comprising Si or Mn so as to have a Si content of 2.5% by mass or more, or have a Mn content of 5.5% by mass or more. The resulting backing plate using any of the above-mentioned existing aluminum alloys is resistant to hardening and to cracking even when heat stress is applied as a result of welding. In addition, the backing plate readily has sufficient corrosion resistance and can serve to prevent corrosion even when a cooling water is allowed to pass through a cooling channel arranged for cooling the target. The above aluminum alloys are widely used as expanded materials and are thereby easily available. When the backing plate comprises an aluminum alloy containing high-purity aluminum, such as four-nines aluminum (4N-Al) , and further comprising Si or Mn, the corrosion of the backing plate due to the cooling water passing therethrough can be significantly inhibited.

These aluminum alloys have thermal conductivities lower than those of Cu-based materials but can serve to cool the brazed target sufficiently.

The aluminum alloy constituting the backingplate according to the present invention preferably further comprises Mg for further increasing the corrosion resistance and strength. The Mg content is, if added, preferably 0.3% by mass or more for exhibiting these advantages effectively and is preferably 3% by mass or less for avoiding defects after welding caused by excessive Mg.

For significantly reducing defects such as cracking of the brazing filler metal, the backing plate for sputtering targets according to the present invention is preferably used as a backing plate for aluminum alloy sputtering targets featured by relatively low coefficients of linear expansion among regular sputtering targets. It is specifically preferably used as a backing plate for aluminum alloy sputtering targets containing 0.1 to 3 atomic % of Nd featured by low coefficients of linear expansion. In the latter case, defects such as cracking of the brazing filler metal can be further significantly reduced.

The backing plate for sputtering targets according to the present invention is not specifically limited in its shape and dimensions and can have a variety of shapes such as rectangular shape or orbicular shape. The present invention is preferably applied to a large-sized backing plate having an area in a brazing portion brazed with the target of 0.25 m² or more. This is because the defects such as cracking of the brazing filler metal caused by difference in coefficient of linear expansion between the target and the backing plate become significant with increasing sizes of the target and the backing plate.

The backing plate for sputtering targets according to the present invention may have an inner structure for cooling the target. The cooling structure can be any conventional structure. For example, two members for constituting the backing plate is bonded typically by welding, friction welding or diffusion bonding so as to form a coolant passage in the backing plate. In addition or alternatively, any facilities such as power source or mounting parts for mounting to a film deposition equipment may be mounted to the backing plate.

The backing plate according to the present invention is subjected to film deposition while having the target brazed onto its plane surface. The brazing filler metal and brazing method herein are not specifically limited and conventional or general materials and methods can be employed. The backing plate enables repetitive film deposition satisfactorily even using a regular brazing filler metal such as indium, lead-tin solder or tin-zinc solder.

The fabricating method of the backing plate for sputtering targets according to the present invention is not specifically limited. The backing plate may be fabricated, for example, by fabricating an ingot of an aluminum alloy having a specific Si or Mn content, forging and rolling the ingot according to a conventional procedure to form a flat plate, and subjecting the flat plate to machining and bonding such as welding.

The present invention will be illustrated in further detail with reference to several experimental examples below which by no means limit the scope of the present invention. Any modification of such examples without deviating from the scope of the present invention is within the technical range of the present invention.

Each of the testedmaterials in Tables 1 and 2 was fabricated as an ingot, and the ingot was subjected to rolling and machining to yield test samples. The average coefficient of linear expansion of the test samples was determined using a testing instrument Thermoflex TMA8140available from Rigaku Corporation according to "Test Method of Coefficient of Linear Expansion of Plastics by Thermomechanical Analysis" specified in Japanese Industrial Standards (JIS) K 7197. The results are shown in Tables 1 and 2.

**Table 1**

| Sample No. | Tested material | Average coefficient of linear expansion at 25°C to 100°C (x10⁻⁶/°C) |
|---|---|---|
| 1 | A1100 +7 mass % Si | 22.4 |
| 2 | A5052 +7 mass % Si | 22.3 |
| 3 | 4N-Al +7 mass % Si | 22.3 |
| 4 | A5052 | 24.5 |
| 5 | Al-2 atomic % Nd | 22.8 |
| 6 | Al-0.6 atomic % Nd | 23.6 |

**Table 2**

| Sample No. | Tested material | Average coefficient of linear expansion at 25°C to 100°C(×10⁻⁶/°C) |
|---|---|---|
| 7 | 4N-Al+4mass%Mn | 23.4 |
| 8 | A1100+4mass%Mn | 23.4 |
| 9 | A5052+4mass%Mn | 23.3 |
| 10 | A6063+4mass%Mn | 23.3 |
| 11 | 4N-Al+5.5mass%Mn | 23.0 |
| 12 | A1100+5.5mass%Mn | 23.0 |
| 13 | A5052+5.5mass%Mn | 22.9 |
| 14 | A6063+5.5mass%Mn | 22.8 |
| 15 | 4N-AI+10mass%Mn | 21.5 |
| 16 | A1100+10mass%Mn | 21.4 |
| 17 | A5052+10mass%Mn | 21.2 |
| 18 | A6063+10mass%Mn | 21.3 |
| 19 | 4N-Al+3mass%Si-6mass%Mn | 22.0 |
| 20 | A1100+3mass%Si+6mass%Mn | 22.0 |
| 21 | A5052+3mass%Si+6mass%Mn | 21.8 |
| 22 | A6063+3mass%Si+6mass%Mn | 21.9 |

Tables 1 and 2 demonstrate that Sample No. 4 comprising an aluminum alloy of JIS A 5052 has a high coefficient of linear expansion regardless of annealing conditions. In contrast, Sample Nos. 1-3 and 11-22 have coefficients of linear expansion of 23.0x10⁻⁶/°C or less and can be used as backing plates for sputtering targets comprising aluminum alloys featured by low coefficients of linear expansion.

These results also show that addition of Si or Mn to pure metallic aluminum or aluminum alloys according to the JIS specifications for achieving backing plates for sputtering targets comprising aluminum alloys featured by low coefficients of linear expansion. As illustrated in FIG. 2 and FIG. 3, the addition of Si in an amount of 2.5% by mass or more, or the addition of Mn in an amount of 5.5% by mass or more to aluminum alloys according to the JIS specifications can achieve a coefficient of linear expansion of 23.0×10⁻⁶/°C or less. In this connection, the addition of Si or Mn to other aluminum alloys also yields the same advantages.

Sample Nos. 5 and 6 comprise Al-Nd alloy materials that can be used as targets, whose coefficients of linear expansion were determined in the same manner as above. The problems caused by the difference in coefficient of linear expansion between the target and the backing plate can be solved by using, as material for the backing plate, the same material as the target. Even without using such high-cost materials, however, the difference in coefficient of linear expansion between the backing plate and the target can be reduced to thereby inhibit the warp, by adding Si or Mn to aluminum alloys and to thereby reduce the coefficients of linear expansion.

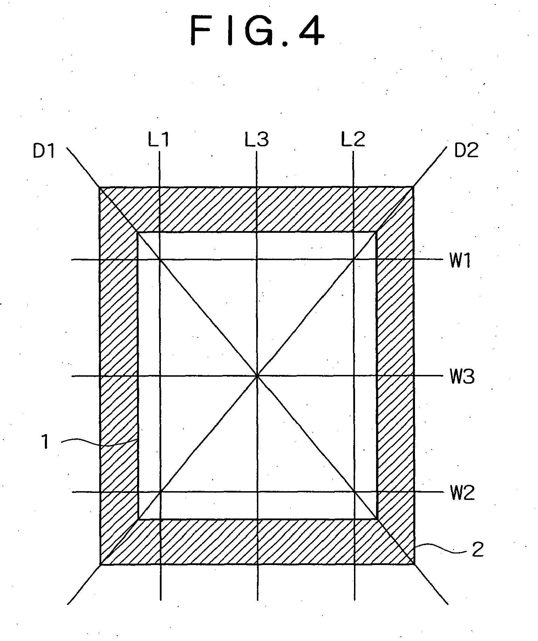

Next, an Al-Nd alloy target was bound to a series of backing plates (cooling plates) comprising a variety of materials, and the warp of the samples after bonding was determined. Specifically, a target 400 mm long and 500 mm wide and a backing plate 420 mm long and 520 mm wide in Tables 3 and 4 were bonded using a tin-zinc solder at a temperature of 250°C. The warp of the resulting assembly was determined at points illustrated in FIG. 4. The results are shown in Tables 3 and 4. The measurement points such as L1 and L2 in Table 2 represent the measurement points in FIG. 4.

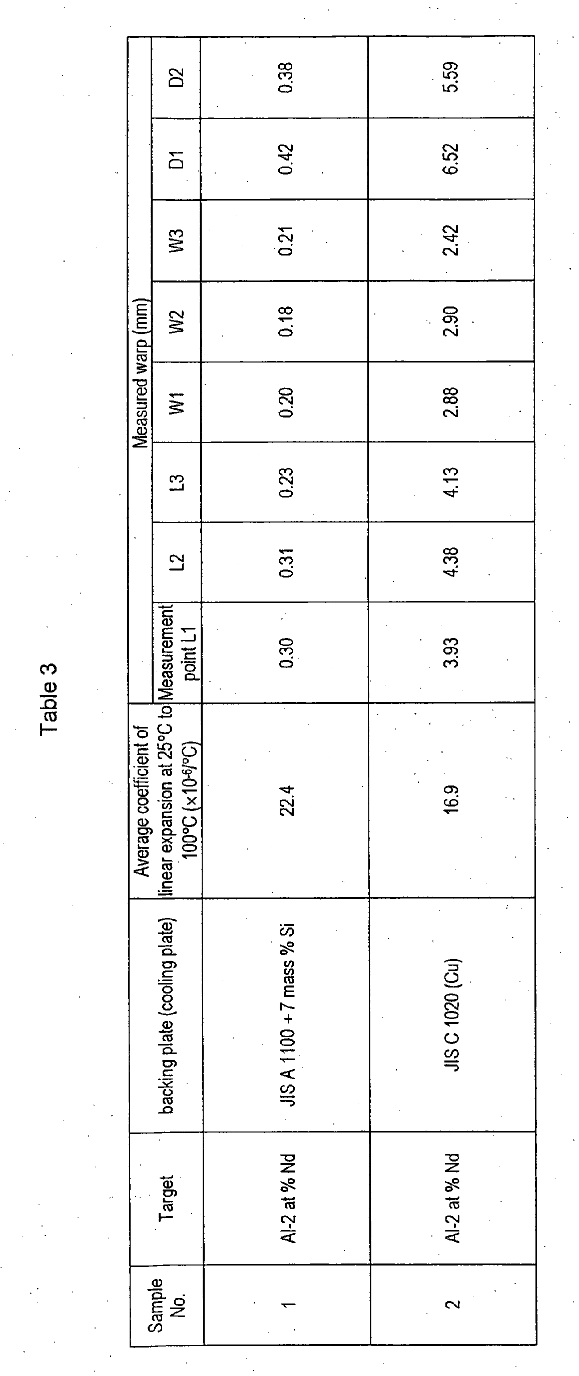

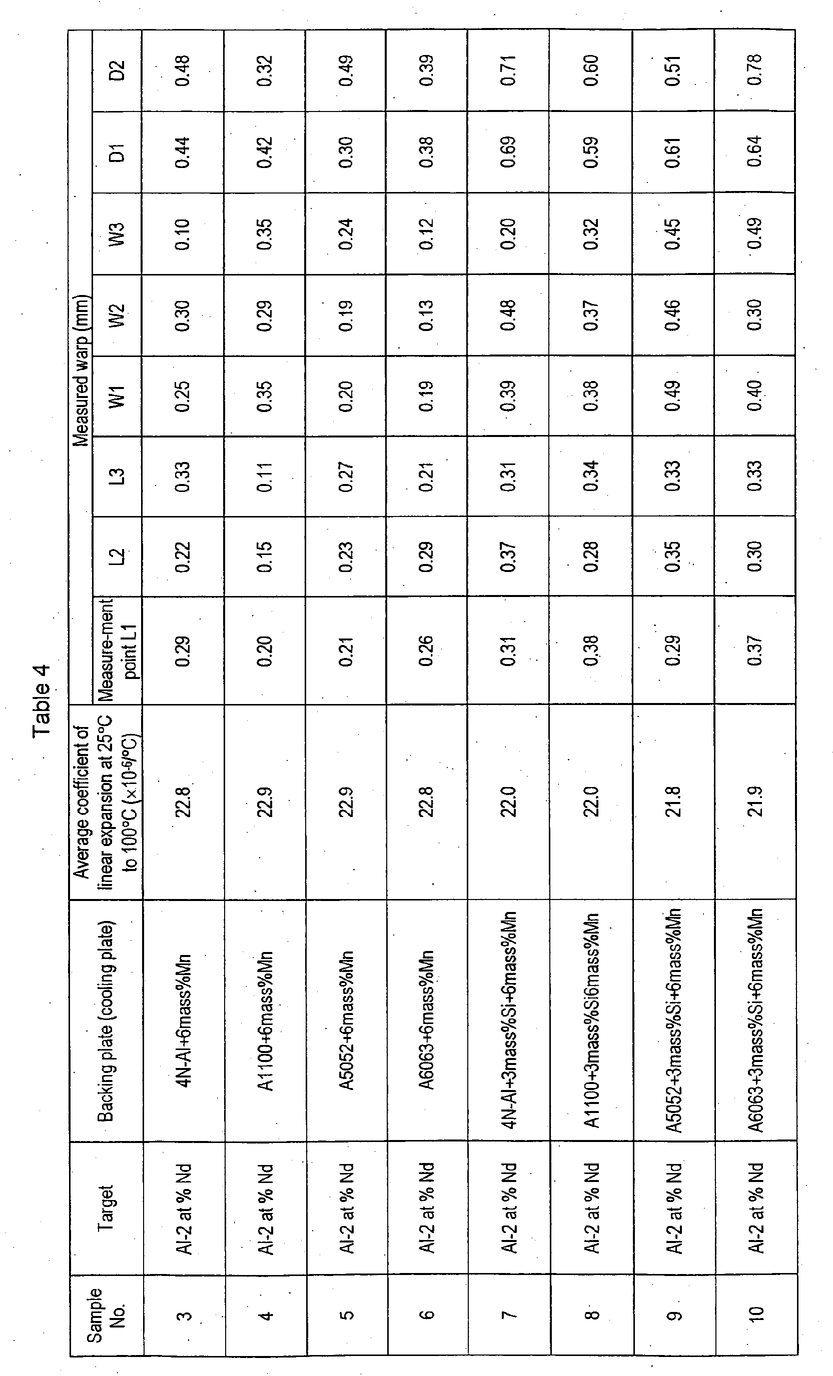

Tables 3 and 4 demonstrate that Sample Nos. 1 and 3-10 using a backingplate forAl-Nd alloy targets satisfying the requirements in the present invention can inhibit the warp further more markedly than Sample No. 2 using the other backing plate.

While the present invention has been described with reference to what are presently considered to be the preferred embodiments, it is to be understood that the invention is not limited to the disclosed embodiments. On the contrary, the invention is intended to cover various modifications and equivalent arrangements included within the spirit and scope of the appended claims. The scope of the following claims is to be accorded the broadest interpretation so as to encompass all such modifications and equivalent structures and functions.

## Claims

1. A backing plate for sputtering targets, comprising an aluminum alloy, wherein the aluminum alloy has an average coefficient of linear expansion of 23.0×10⁻⁶/°C or less at temperatures of 25°C to 100°C.

2. The backing plate according to claim 1, wherein the aluminum alloy comprises 2.5% by mass or more of Si.

3. The backing plate according to claim 2, wherein the aluminum alloy comprises at least one selected from the group consisting of aluminum alloys of Japanese Industrial Standards (JIS) A 1000 series, A 5000 series, and A 6000 series and further comprises Si.

4. The backing plate according to claim 1 or 2, wherein the aluminum alloy comprises 5.5% by mass or more of Mn.

5. The backingplate according to claim 4, wherein the aluminum alloy comprises at least one selected from the group consisting of aluminum alloys of Japanese Industrial Standards (JIS) A1000 series, A5000 series, and A6000 series and further comprises Mn.

6. The backing plate according to **any one of claims 1 to 5, as a backing plate** for aluminum alloy sputtering targets.

7. The backing plate according to any one of claims 1 to 6, as a backing plate for aluminum alloy sputtering targets containing 0. 1 to 3 atomic % of Nd.
